# EUROPEAN PATENT APPLICATION

(11) **EP 4 760 333 A1**
(43) Date of publication of application: **17.06.2026**
(21) Application number: 24886063.7
(22) Date of filing: 14.10.2024
(51) Int. Cl.: G01R 35/00, G01R 31/371, G08C 23/04, G01R 23/00, G01R 23/16, G01R 19/165

(54) **DIAGNOSTIC DEVICE AND OPERATING METHOD THEREOF**

(30) Priority: 30.10.2023 KR 20230146831
(71) Applicant: LG Energy Solution, Ltd., Seoul 07335 (KR)
(72) Inventor: YOON, Sun Woo, Daejeon 34122 (KR)
(74) Representative: Plasseraud IP
(86) International application number: PCT/KR2024/015526
(87) International publication number: WO 2025/095388

(57) **Abstract**

A diagnosis apparatus according to an embodiment disclosed herein includes a first information generation unit configured to receive an infrared (IR) signal transmitted from an external transmitter and generate first information related to a frequency of the IR signal, a second information generation unit configured to receive the IR signal and generate second information related to a light quantity of the IR signal, and a processor configured to diagnose a state of the transmitter based on the first information and the second information.

## Description

### Technical Field

### CROSS-REFERENCE TO RELATED APPLICATION

This application claims priority to and the benefit of Korean Patent Application No. 10-2023-0146831 filed in the Korean Intellectual Property Office on October 30, 2023, the entire content of which is incorporated herein by reference.

### TECHNICAL FIELD

An embodiment disclosed herein relates to a diagnosis apparatus and an operating method thereof.

### Background Art

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

A battery management apparatus that controls an overall operation of the secondary battery communicates with the outside in a wireless communication manner such as wired and/or infrared communication. In the battery management apparatus that communicates with the outside in the infrared communication manner, positions of a transmission unit transmitting an infrared signal and a reception unit receiving an infrared signal are fixed, making it difficult to perform diagnosis on infrared communication quality.

### Disclosure

### Technical Problem

An embodiment disclosed herein relates to a diagnosis apparatus and an operating method thereof to verify an operation state of a battery management apparatus that communicates based on infrared rays.

Technical problems of the embodiments disclosed herein are not limited to the aforementioned technical problems, and other unmentioned technical problems would be clearly understood by those of ordinary skill in the art from the following description.

### Technical Solution

A diagnosis apparatus according to an embodiment disclosed herein includes a first information generation unit configured to receive an infrared (IR) signal transmitted from an external transmitter and generate first information related to a frequency of the IR signal, a second information generation unit configured to receive the IR signal and generate second information related to a light quantity of the IR signal, and a processor configured to diagnose a state of the transmitter based on the first information and the second information.

According to an embodiment, the first information generation unit may include a conversion unit configured to convert the IR signal into an electrical signal and a filter unit including a resistor-capacitor (RC) filter to delay the converted electrical signal for a preset time, in which the first information is related to the electrical signal delayed for the preset time.

According to an embodiment, the processor may be further configured to diagnose an operation state of the transmitter based on a result of comparison between a frequency of the delayed electrical signal, obtained based on the first information, and a preset reference frequency.

According to an embodiment, the second information generation unit may include a conversion unit configured to convert the IR signal into an electrical signal and a storage unit including a capacitor to store energy related to the converted electrical signal, in which the second information is related to a level of a voltage applied to opposite ends of the capacitor.

According to an embodiment, the processor may be further configured to diagnose the operation state of the transmitter based on a result of comparison between a voltage level obtained based on the second information and a preset voltage level.

According to an embodiment, the reference voltage level may be related to a distance between the diagnosis apparatus and the external transmitter.

According to an embodiment, the external may correspond to a transmission unit of a battery management system (BMS) that performs IR communication.

An operating method of a diagnosis apparatus according to an embodiment disclosed herein includes receiving an infrared (IR) signal transmitted from outside, converting the IR signal into an electrical signal, verifying a frequency of the IR signal based on first information generated based on the electrical signal, and verifying a light quantity of the IR signal based on second information generated based on the electrical signal.

According to an embodiment, the first information may be related to a frequency of a signal obtained by delaying the electrical signal for a preset reference time, and the second information may be related to energy of the electrical signal.

According to an embodiment, the verifying of the frequency of the IR signal may include obtaining a frequency of a signal delayed for the reference time based on the first information, comparing the frequency of the signal delayed for the reference time with a preset reference frequency, and verifying the frequency of the IR signal based on a result of comparison in frequency.

According to an embodiment, the verifying of the light quantity of the IR signal may include obtaining a level of a voltage applied to opposite ends of a capacitor that stores energy of the electrical signal based on the second information, comparing the level of the voltage obtained based on the second information with a preset reference voltage level, and verifying the light quantity of the IR signal based on a result of comparison in voltage level.

According to an embodiment, the reference voltage level may be determined based on a distance between the outside and the diagnosis apparatus, and the outside may correspond to a transmission unit of a battery management system (BMS) that performs IR communication.

### Advantageous Effects

According to an embodiment disclosed herein, there are provided a diagnosis apparatus and an operating method thereof to verify an operation state of a battery management apparatus that communicates based on infrared (IR) rays.

The effects according to an embodiment disclosed in the present document are not limited to the effects mentioned above, and other effects not mentioned will be clearly understood by those of ordinary skill in the art according to the disclosure of the present document.

### Description of Drawings

FIG. 1 is a view for schematically describing a diagnosis apparatus and peripheral components according to an embodiment disclosed herein.
FIG. 2 is a view for describing a diagnosis apparatus according to an embodiment disclosed herein.
FIG. 3 is a view for describing first information according to an embodiment disclosed herein.
FIGS. 4A and 4B are views for describing second information according to an embodiment disclosed herein.
FIG. 5 is a flowchart for describing an operation of a diagnosis apparatus according to an embodiment disclosed herein.

### Mode for Invention

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

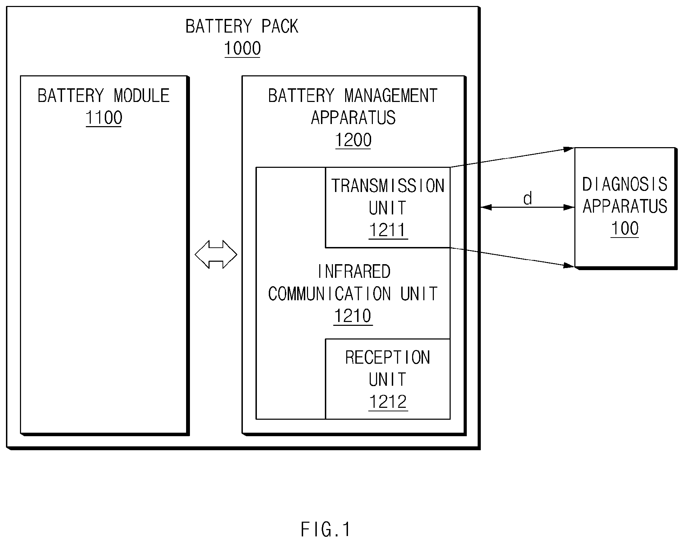

FIG. 1 is a view for schematically describing a diagnosis apparatus and peripheral components according to an embodiment disclosed herein.

Referring to FIG. 1, a diagnosis apparatus 100 may be configured to diagnose a state of a transmission unit 1210 of a battery management apparatus 1200.

A battery pack 1000 may include a battery module 1100 and a battery management apparatus 1200.

The battery module 1100 may include a plurality of battery cells (not shown). Herein, the plurality of battery cells (not shown) may be, but not limited to, a lithium ion (Li-ion) battery, an Li-ion polymer battery, a nickel-cadmium (Ni-Cd) battery, a nickel hydrogen (Ni-MH) battery, etc.

The battery module 1100 may be configured to be connected to a target device (not shown) and supply power to the target device. To this end, the battery module 1100 may be electrically connected to the target device (not shown). The target device may include an electrical, electronic or mechanical device that operates by receiving power from the battery module 1100, and for example, the target device (not shown) may be, but not limited to, an electric vehicle (EV).

In FIG. 1, the battery pack 1000 is illustrated as including one battery module 1100, but the present disclosure is not limited to this example, and the battery pack 1000 may include at least one battery module.

The battery management apparatus 1200 may control the overall operation of the battery pack 1000. For example, the battery management apparatus 1200 may manage and/or control a state and/or an operation of the battery module 1100 and/or the plurality of battery cells (not shown) included in the battery module 1100. The battery management apparatus 1200 may manage charging and/or discharging of the battery module 1100.

The battery management apparatus 1200 may measure at least one of voltage, current, temperature, and resistance of the battery module 1100 and/or each of the plurality of battery cells (not shown) included in the battery module 1100 and/or communicate with the outside to provide the measured voltage, current, temperature, resistance, etc., of the battery module 1100 and/or each of the plurality of battery cells (not shown) included in the battery module 1100. The battery management apparatus 1200 may communicate with the outside using a wired and/or wireless communication scheme in which the outside may include, but not limited to, a battery management apparatus (not shown) and/or a higher-level controller, etc., included in another battery pack (not shown).

According to an embodiment, the battery management apparatus 1200 may communicate with the outside based on an infrared (IR) communication scheme. Herein, IR communication, which is a sort of wireless communication among various wired and/or wireless communication schemes, may be a scheme to transmit data and/or communicate between electronic devices remotely using IR. The IR communication may be performed between an IR transmission unit that generates and/or transmits IR and an IR reception unit that receives transmitted IR rays.

The battery management apparatus 1200 may include an IR communication unit 1210 that performs IR communication, and the IR communication unit 1210 may include a transmission unit 1211 that generates and/or transmits an IR signal and a reception unit 1212 that receives the IR signal transmitted from the outside.

According to an embodiment, the transmission unit 1211 may include a light-emitting diode (LED) that generates IR rays. The IR transmission unit may be configured to adjust a strength of IR rays generated by the LED by adjusting a magnitude of current flowing through the LED.

According to an embodiment, the reception unit 1212 may include a semiconductor device having a light detection function, such as a sensor capable of detecting IR rays, such as a photodiode. The IR reception unit may be configured to interpret and/or process an IR signal transmitted by the IR transmission unit by converting current flowing through the photodiode into an electrical signal. However, this is merely an example, and the IR communication unit 1210 may be configured variously to perform IR communication or may further include various components not described.

The battery management apparatus 1200 may control the IR communication unit 1210 to generate and/or transmit a test IR signal for diagnosing a communication state of the IR communication unit 1210. Herein, the test IR signal may be a signal having a preset constant frequency and constant light quantity. According to an embodiment, the battery management apparatus 1200 may control the IR communication unit 1210 to transmit the test IR signal having the preset constant frequency and constant light quantity for diagnosing the state of the transmission unit 1211 to the outside.

The diagnosis apparatus 100 may be configured to diagnose the state of the transmission unit 1211. The diagnosis apparatus 100 may be configured to diagnose the state of the transmission unit 1211 at a position distant from the transmission unit 1211 by a reference distance d.

According to an embodiment, the diagnosis apparatus 100 may receive the test IR signal transmitted by the transmission unit 1211 and diagnose the state of the transmission unit 1211 based on the received test IR signal.

According to an embodiment, the diagnosis apparatus 100 may receive the test IR signal transmitted by the transmission unit 1211 and diagnose the state of the transmission unit 1211 based on a frequency and a light quantity of the test IR signal.

According to an embodiment, the diagnosis apparatus 100 may convert the test IR signal into an electrical signal, delay the converted electrical signal for a preset time, and obtain a frequency of the delayed electrical signal.

According to an embodiment, the diagnosis apparatus 100 may compare the frequency of the delayed electrical signal with a constant reference frequency of the preset test IR signal. Assuming that the transmission unit 1211 operates normally, the transmission unit 1211 may normally transmit the test IR signal having a preset frequency, such that the frequency of the electrical signal obtained by the diagnosis apparatus 100 may also be the same as and/or similar to the preset reference frequency. Accordingly, the diagnosis apparatus 100 may diagnose that the state of the transmission unit 1211 is normal when a difference between the frequency of the obtained electrical signal and the preset reference frequency is within an error range.

According to an embodiment, a second information generation unit 120 (see FIG. 1) may convert the test IR signal into an electrical signal, store energy related to the converted electrical signal, and obtain a voltage level value related to the energy of the converted electrical signal.

According to an embodiment, the diagnosis apparatus 100 may compare the voltage level value related to the energy of the converted electrical signal with a reference voltage level of the preset test IR signal described above. Assuming that the transmission unit 1211 operates normally, the transmission unit 1211 may normally transmit the test IR signal having a preset light quantity, such that the light quantity of the electrical signal obtained by the diagnosis apparatus 100 may also be the same as and/or similar to the preset light quantity. Accordingly, the diagnosis apparatus 100 may diagnose that the state of the transmission unit 1211 is normal when a difference between the voltage level of the obtained electrical signal and the preset reference voltage level is within an error range.

According to an embodiment, the reference voltage level may be related to the distance d between the diagnosis apparatus 100 and the transmission unit 1211. IR communication may transmit and receive data based on an IR signal such that the light quantity of the IR signal received by the reception unit may decrease as a distance between the transmission unit and the reception unit increases. Thus, diagnosis may be performed by differently setting the reference voltage level based on the distance between the diagnosis apparatus 100 and the transmission unit 1211.

According to an embodiment, the error ranges for the frequency and the light quantity may be set and changed variously based on an allowable error range, etc.

According to an embodiment, the diagnosis apparatus 100 may diagnose that a communication state of the transmission unit 1211 is normal when a result of comparing the frequency obtained from the test IR signal transmitted from the transmission unit 1211 with the reference frequency and a result of comparing the voltage level obtained from the test IR signal with the reference voltage level are normal.

According to an embodiment, the diagnosis apparatus 100 may be implemented in the form of an on-board diagnosis (OBD) diagnosis apparatus. In this case, the diagnosis apparatus 100 may receive the test IR signal from the transmission unit 1211 emitting light closely to the transmission unit 1211 to perform diagnosis on the transmission unit 1211.

According to an embodiment, the diagnosis apparatus 100 may be configured to diagnose the state of the transmission unit 1211 that performs IR communication at production and processing stages of the battery pack 1000. For example, the diagnosis apparatus 100 may be configured to diagnose the state of the transmission unit 1211 during end of line (EOL)inspection at a processing stage including production and verification, etc., of the battery pack 1000.

According to an embodiment, the diagnosis apparatus 100 may be configured to diagnose a communication state between a plurality of battery packs (not shown) included in an energy storage system (ESS). For example, as there may be a space between a plurality of battery packs that perform IR communication included in the ESS, the communication state between the battery packs that perform IR communication may be diagnosed by positioning the diagnosis apparatus 100 in a space between the battery packs.

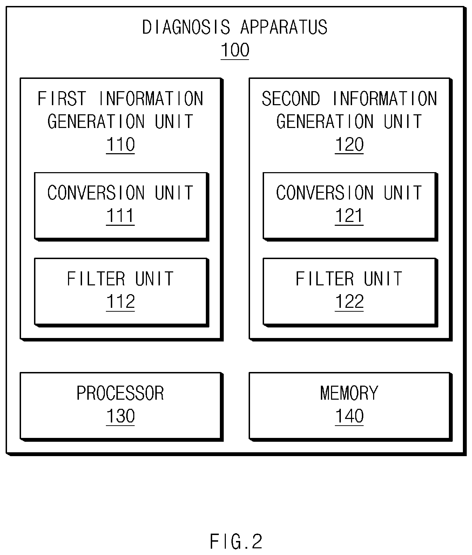

FIG. 2 is a view for describing a diagnosis apparatus according to an embodiment disclosed herein.

The diagnosis apparatus 100 may be configured to receive an IR signal transmitted from the outside, particularly, an IR transmitter outside and diagnose the IR transmitter based on the received IR signal. The diagnosis apparatus 100 may include a first information generation unit 110, the second information generation unit 120, a processor 130, and a memory 140.

According to an embodiment, the first information generation unit 110 may include a conversion unit 111 and a filter unit 112. Herein, the conversion unit 111 may be configured to convert an IR signal transmitted from an external transmitter into an electrical signal.

For example, the conversion unit 111 may be configured to, but not limited to, convert the IR signal into the electrical signal based on current flowing through the photodiode, etc., detecting IR rays transmitted from the external transmitter.

The filter unit 112 may be configured to delay the electrical signal converted by the conversion unit 111 for a preset time. For example, the filter unit 112 may include, but not limited to, a resistor-capacitor (RC) filter. A delay time may be determined by an RC constant and may be set and changed variously according to a design value.

According to an embodiment, the first information generation unit 110 may be configured to generate first information. Herein, the first information may be related to a frequency of an IR signal transmitted from the external transmitter. For example, the first information generation unit 110 may generate an electrical signal, obtained by delaying the IR signal, transmitted by the external transmitter, which has been converted into the electrical signal by the conversion unit 111, for a preset time. Herein, the first information may include information related to the frequency of the electrical signal delayed for the preset time.

According to an embodiment, the second information generation unit 120 may include a conversion unit 121 and a storage unit 122. Herein, the conversion unit 121 may be configured to convert an IR signal transmitted from an external transmitter into an electrical signal. For example, the conversion unit 111 may be configured to, but not limited to, convert the IR signal into the electrical signal based on current flowing through the photodiode, etc., detecting IR rays transmitted from the external transmitter. While it is shown in FIG. 2 that the first information generation unit 110 and the second information generation unit 120 respectively include the conversion unit 111 and the conversion unit 121, the present disclosure is not limited to this example and the conversion units 111 and 121 may be implemented as one component for converting the IR signal transmitted from the external transmitter into an electrical signal.

According to an embodiment, the storage unit 122 may be configured to store energy related to the electrical signal converted by the conversion unit 121. For example, the storage unit 122 may include a capacitor that stores energy.

According to an embodiment, a capacitor included in the storage unit 122 may store energy related to the electrical signal converted by the conversion unit 121.

According to an embodiment, the second information generation unit 120 may be configured to generate second information. Herein, the second information may be related to energy of the IR signal transmitted from the external transmitter. For example, the second information generation unit 120 may store energy related to the IR signal, transmitted by the external transmitter, which has been converted into the electrical signal by the conversion unit 121. Herein, the second information may include information related to a voltage applied to opposite ends of the capacitor.

The processor 130 may control overall operations of the diagnosis apparatus 100.

According to an embodiment, the processor 130 may execute software to control at least one other component (e.g., hardware or software) of the diagnosis apparatus 100 or perform operations such as processing and/or calculating various data, etc.

The processor 130 may perform an operation of diagnosing the state of the external transmitter based on the first information and the second information.

According to an embodiment, the processor 130 may be configured to diagnose an operation state of the transmitter by comparing the frequency of the electrical signal obtained based on the first information with the preset reference frequency. Herein, the preset reference frequency may be defined as a frequency predetermined to be transmitted by the external transmitter. For example, the test IR signal transmitted to diagnose a communication state by the external transmitter may have a constant frequency and a constant light quantity. The preset reference frequency may be related to the frequency of the test IR signal described above.

According to an embodiment, the processor 130 may be configured to diagnose the operation state of the transmitter by comparing a level of a voltage applied to opposite ends of the capacitor with the preset reference voltage level in which the level of the voltage is related to the energy of the electrical signal obtained based on the second information. Herein, the preset reference voltage level may be defined as energy related to the light quantity of the test IR signal predetermined to be transmitted by the external transmitter.

According to an embodiment, the processor 130 may diagnose that the operation state and/or communication state of the external transmitter is normal when a difference between the frequency of the electrical signal obtained based on the first information and the reference frequency is within a threshold value and a difference between the level of the voltage obtained based on the second information and the reference voltage level is within a threshold value. Herein, the threshold value may be set and applied variously according to an allowable error range and/or a circuit design of the external transmitter, etc.

The memory 140 may be configured to store data related to the reference frequency and the reference voltage level and/or store various data generated by the diagnosis apparatus 100. According to an embodiment, the memory 140 may include, but not limited to, a volatile memory device such as static random access memory (SRAM) or dynamic random access memory (DRAM) and a non-volatile memory device such as read only memory (ROM), programable ROM (PROM), and flash memory.

As described above, the diagnosis apparatus 100 according to an embodiment disclosed herein may receive an IR signal transmitted from the external transmitter and perform analysis on frequency and light quantity in parallel based on the received IR signal. The diagnosis apparatus 100 may be implemented as a separate device to perform diagnosis on the battery pack 1000 that performs IR communication, regardless of an environment. The test IR signal and a criterion with respect to frequency and light quantity related thereto may be set differently based on a distance and/or an allowable error, etc., between the diagnosis apparatus 100 and the battery pack 1000, enabling flexible diagnosis on the transmission unit 1112.

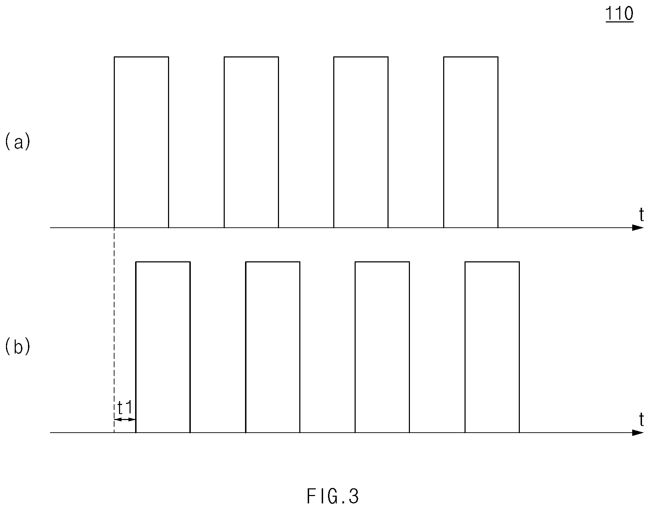

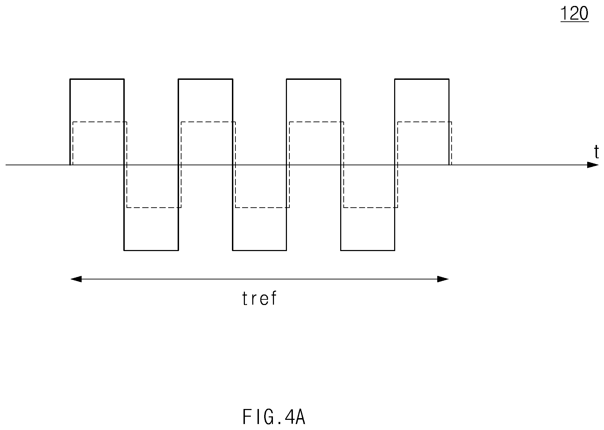

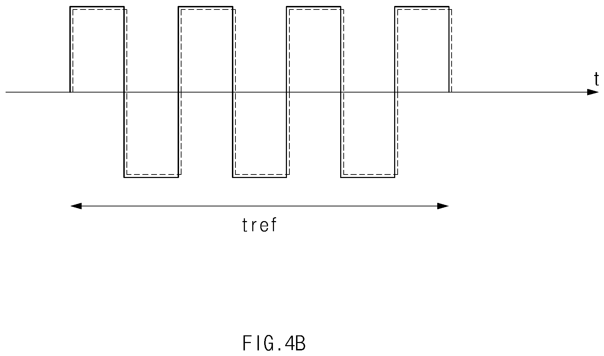

FIGS. 3, 4A, and 4B are views for describing an operation of the diagnosis apparatus 100.

FIG. 3 is a view for describing the first information according to an embodiment disclosed herein, and FIGS. 4A and 4B are views for describing the second information according to an embodiment disclosed herein.

Referring to FIG. 3, an electrical signal generated by the first information generation unit 110 (see FIG. 2) is shown.

As described above, the first information generation unit 110 may receive the IR signal transmitted from the external transmitter and convert the received IR signal into an electrical signal. Herein, the IR signal may be the same as the above-described test IR signal. For example, the first information generation unit 110 may convert the received IR signal into the electrical signal to generate a signal (a) like a pulse waveform having a constant frequency. However, the waveform of the signal shown in FIG. 3 is illustrated for convenience of a description and is not limited to an example having a waveform and/or a frequency, etc., as shown in FIG. 3.

The first information generation unit 110 may delay the IR signal (a) converted into the electrical signal for a preset time t1. According to an embodiment, the first information generation unit 110 may generate a delayed signal (b) by passing the signal (a) converted into the electrical signal through an RC filter. Herein, the preset time t1 may be set and changed variously according to a resistance of the RC filter and a capacitance of the capacitor. The first information generation unit 110 may obtain a frequency based on a waveform of the signal delayed for the preset time t1.

Referring to FIGS. 4A and 4B, an electrical signal generated by the second information generation unit 120 (see FIG. 2) is shown.

As described above, the second information generation unit 120 may receive the IR signal transmitted from the external transmitter and convert the received IR signal into an electrical signal. Herein, the IR signal may be the same as the above-described test IR signal. For example, the second information generation unit 120 may convert the received IR signal into the electrical signal to generate a signal like a pulse waveform having a constant frequency. Referring to FIGS. 4A and 4B, an IR signal converted into an electrical signal may correspond to a graph expressed as a dotted line. The graph shown expressed as the dotted line may indicate a signal assuming that there is no loss in the light quantity of the preset test IR signal. However, the waveform of the signal shown in FIGS. 4A and 4B is illustrated for convenience of a description and is not limited to an example having a waveform and/or a frequency, etc., as shown in FIGS. 4A and 4B.

According to an embodiment, assuming that there is a loss in the light quantity of the IR signal transmitted from the external transmitter, as shown in FIG. 4A, the level of the electrical signal converted from the IR signal transmitted from the external transmitter may be less than the level of the test IR signal. In this case, a voltage accumulated for a reference time tref and applied to opposite ends of the capacitor included in the storage unit 122 (see FIG. 2) may be less than the reference voltage level by at least a threshold value.

According to an embodiment, assuming that there is no loss in the light quantity of the IR signal transmitted from the external transmitter, as shown in FIG. 4B, the level of the electrical signal converted from the IR signal transmitted from the external transmitter may be the same as or similar to the level of the test IR signal, even considering a loss corresponding to the distance d between the diagnosis apparatus 100 and the transmission unit 1211. In this case, a voltage accumulated for the reference time tref and applied to the opposite ends of the capacitor included in the storage unit 122 (see FIG. 2) may be similar to the reference voltage level or may be within a threshold value.

As described above, the diagnosis apparatus 100 may diagnose the operation state of the transmission unit 1211 based on a result of comparison in frequency and a result of comparison in voltage level.

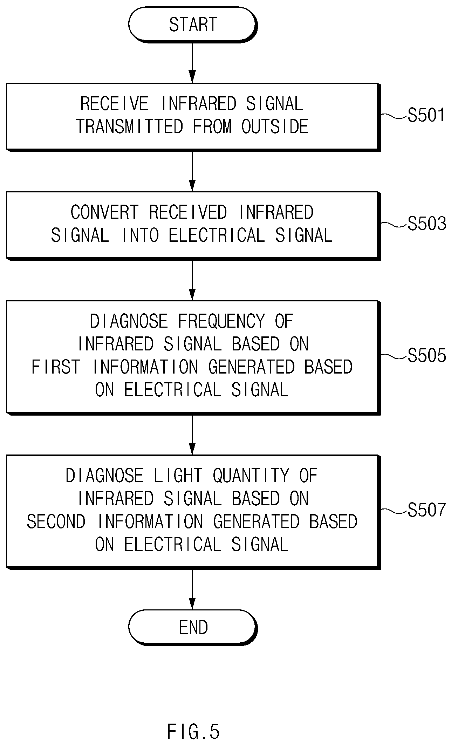

FIG. 5 is a flowchart for describing an operation of a diagnosis apparatus according to an embodiment disclosed herein.

In operation S501, the diagnosis apparatus 100 (see FIG. 2) may receive an IR signal transmitted from the external. According to an embodiment, the external may correspond to the transmission unit of the BMS that performs IR communication, and the external transmitter may be configured to output the test IR signal having a preset reference frequency level and a preset reference voltage level.

In operation S503, the diagnosis apparatus 100 may convert the received IR signal into the electrical signal. According to an embodiment, the diagnosis apparatus 100 may be configured to, but not limited to, convert the IR signal into the electrical signal based on current flowing through the photodiode, etc., detecting IR rays transmitted from the external transmitter.

In operation S505, the diagnosis apparatus 100 may diagnose the frequency of the IR signal based on the first information generated based on the converted electrical signal. According to an embodiment, an operation of verifying the frequency of the IR signal may include an operation of obtaining the frequency of the signal delayed for the reference time based on the first information, an operation of comparing the frequency of the signal delayed for the reference time with the preset reference frequency, and an operation of verifying the frequency of the IR signal based on a result of comparison in frequency. Herein, the preset reference frequency may be defined as the frequency of the test IR signal predetermined to be transmitted by the external transmitter. For example, the test IR signal transmitted to diagnose a communication state by the external transmitter may have a constant frequency and a constant light quantity. The preset reference frequency may be related to the frequency of the test IR signal described above.

The diagnosis apparatus 100 may diagnose that the state of the transmission unit 1211 is normal when a frequency difference is within a threshold value as the comparison result.

In operation S507, the diagnosis apparatus 100 may diagnose the light quantity of the IR signal based on the second information generated based on the converted electrical signal. According to an embodiment, an operation of verifying the light quantity of the IR signal may include an operation of obtaining the level of the voltage applied to the opposite ends of the capacitor that stores the energy of the electrical signal based on the second information, an operation of comparing the level of the voltage obtained based on the second information with the preset reference voltage level, and an operation of verifying the light quantity of the IR signal based on a result of comparison in voltage level. Herein, the reference voltage level may be defined as energy related to the light quantity of the test IR signal predetermined to be transmitted by the external transmitter.

According to an embodiment, the first information may be related to the frequency of the signal obtained by delaying the converted electrical signal for the preset reference time, and the second information may be related to the energy of the converted electrical signal.

So far, all components constituting the embodiment have been described as being combined or combined to operate as one, but it is not necessarily limited to this embodiment, and within the scope of the purpose, all components may be selectively combined with one or more components to operate. Moreover, terms such as "include", "constitute" or "have" described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS DESIGNATING THE MAJOR ELEMENTS OF THE DRAWINGS]

100: DIAGNOSIS APPARATUS
110: FIRST INFORMATION GENERATION UNIT
120: SECOND INFORMATION GENERATION UNIT
130: PROCESSOR
140: MEMORY
1000: BATTERY PACK
1100: BATTERY MODULE
1200: BATTERY MANAGEMENT APPARATUS
1210: INFRARED COMMUNICATION UNIT

## Claims

1. A diagnosis apparatus comprising:
a first information generation unit configured to receive an infrared (IR) signal transmitted from an external transmitter and generate first information related to a frequency of the IR signal;
a second information generation unit configured to receive the IR signal and generate second information related to a light quantity of the IR signal; and
a processor configured to diagnose a state of the transmitter based on the first information and the second information.

2. The diagnosis apparatus of claim 1, wherein the first information generation unit comprises:
a conversion unit configured to convert the IR signal into an electrical signal; and
a filter unit comprising a resistor-capacitor (RC) filter to delay the converted electrical signal for a preset time,
wherein the first information is related to the electrical signal delayed for the preset time.

3. The diagnosis apparatus of claim 2, wherein the processor is further configured to diagnose an operation state of the transmitter based on a result of comparison between a frequency of the delayed electrical signal, obtained based on the first information, and a preset reference frequency.

4. The diagnosis apparatus of claim 1, wherein the second information generation unit comprises:
a conversion unit configured to convert the IR signal into an electrical signal; and
a storage unit comprising a capacitor to store energy related to the converted electrical signal,
wherein the second information is related to a level of a voltage applied to opposite ends of the capacitor.

5. The diagnosis apparatus of claim 4, wherein the processor is further configured to diagnose the operation state of the transmitter based on a result of comparison between a voltage level obtained based on the second information and a preset voltage level.

6. The diagnosis apparatus of claim 5, wherein the reference voltage level is related to a distance between the diagnosis apparatus and the external transmitter.

7. The diagnosis apparatus of claim 1, wherein the external corresponds to a transmission unit of a battery management system (BMS) that performs IR communication.

8. An operating method of a diagnosis apparatus, the operating method comprising:
receiving an infrared (IR) signal transmitted from outside;
converting the IR signal into an electrical signal;
verifying a frequency of the IR signal based on first information generated based on the electrical signal; and
verifying a light quantity of the IR signal based on second information generated based on the electrical signal.

9. The operating method of claim 8, wherein the first information is related to a frequency of a signal obtained by delaying the electrical signal for a preset reference time, and
the second information is related to energy of the electrical signal.

10. The operating method of claim 9, wherein the verifying of the frequency of the IR signal comprises:
obtaining a frequency of a signal delayed for the reference time based on the first information;
comparing the frequency of the signal delayed for the reference time with a preset reference frequency; and
verifying the frequency of the IR signal based on a result of comparison in frequency.

11. The operating method of claim 9, wherein the verifying of the light quantity of the IR signal comprises:
obtaining a level of a voltage applied to opposite ends of a capacitor that stores energy of the electrical signal based on the second information;
comparing the level of the voltage obtained based on the second information with a preset reference voltage level; and
verifying the light quantity of the IR signal based on a result of comparison in voltage level.

12. The operating method of claim 11, wherein the reference voltage level is determined based on a distance between the outside and the diagnosis apparatus, and
the outside corresponds to a transmission unit of a battery management system ( BMS) that performs IR communication.
